Europäisches Patentamt

European Patent Office

Office européen des brevets

(19)

(11) Publication number: 0 312 237
A2

# EUROPEAN PATENT APPLICATION

(12)

(21) Application number: 88309251.2

(51) Int. Cl.⁴: H01L 29/80 , H01L 29/36

(22) Date of filing: 05.10.88

(30) Priority: 13.10.87 US 107822

(43) Date of publication of application:
19.04.89 Bulletin 89/16

(84) Designated Contracting States:
DE FR GB NL

(71) Applicant: AMERICAN TELEPHONE AND
TELEGRAPH COMPANY
550 Madison Avenue
New York, NY 10022(US)

(72) Inventor: Cunningham, John Edward
46 Malibu Drive
Eatontown New Jersey 07724(US)
Inventor: Schubert, Erdmann Fred
127 Village Green Way
Hazlet New Jersey 07730(US)
Inventor: Tsang, Won-Tien
8 Taylor Run
Holmdel New Jersey 07733(US)

(74) Representative: Watts, Christopher Malcolm
Kelway et al
AT&T (UK) LTD. AT&T Intellectual Property
Division 5 Mornington Road
Woodford Green Essex IG8 OTU(GB)

(54) Interface charge enhancement in delta-doped heterostructure.

(57) Interface carrier density for a selectively doped heterostructure in a semiconductor device such as a field effect transistor is increased by forming a delta-doped channel layer in close proximity to a heterointerface and conduction channel. In this structure, two quantum mechanical systems (a planar sheet of charge carriers and the heterointerface) cooperate to reduce a selected barrier thickness below the thickness of an undoped semiconductor spacer layer separating the two systems.

*FIG. 2*

EP 0 312 237 A2

## INTERFACE CHARGE ENHANCEMENT IN DELTA-DOPED HETEROSTRUCTURE

### Technical Field

This invention relates to the field of semiconductor devices and, more particularly, to devices including a delta-doped layer.

### Background of the Invention

Technology of crystal growth continues to provide new materials with new physical properties. For example, selectively doped heterostructures introduced by R. Dingle et al., Appl. Phys. Lett., Vol 33, pp. 665 et seq. (1978) have been made possible by well controlled crystal growth to achieve high carrier mobilities in excess of bulk crystal material and quasi two-dimensional electron gas at the heterointerface. These structures have also permitted observation of fundamental properties such as fractional quantization of the Hall effect.

In these heterostructures, semiconductor layer growth is begun on an intrinsic or semi-insulating Group III-V material substrate such as GaAs. An undoped channel layer of GaAs is grown to a thickness of approximately 1 $\mu$m. This is followed by growth of several $Al_x Ga_{1-x}$ As layers where the mole fraction x is typically in the range of 0.2 to 0.3. The first AlGaAs layer is an undoped spacer layer having a thickness of approximately 0 to 200 Angstroms. This layer is then overgrown by a uniformly doped (n-type or p- type) AlGaAs layer approximately 500 Angstroms thick. An undoped GaAs contact layer (approximately 100 Angstrom thickness) completes the semiconductor heterostructure growth.

As presently understood, heterostructures of the type described above incorporated in devices such as field effect transistors suffer a critical degradation in carrier mobilities for interface electron densities (two dimensional electron gas densities) in excess of approximately $1 \times 10^{12}$ cm$^{-2}$. It is also known that there is a potential drop in the depletion region for these devices which occurs from impurity atoms in the uniformly doped layer.

In an article by T. Ishikawa et al., J. Appl. Phys., vol 61, No. 5, pp. 1937-40 (3/1/87), it has been reported that atomic planar doping has been used to improve the two dimensional electron gas concentration in selectively doped Group III-V heterostructures. The atomic planar doping concentration is chosen to be less than $2.0 \times 10^{12}$cm$^{-2}$. This doping concentration is considered to be dilute. It is important to note that Ishikawa et al. have determined that resulting devices exhibit electron mobility lower than that found in the conventional selectively doped heterostructure devices. In only one device were Ishikawa et al. able to achieve comparable electron mobility to the conventional selectively doped heterostructure. The latter device required the atomic planar doping to be applied directly at the heterointerface.

### Summary of the Invention

Electron mobility is preserved and the two dimensional electron gas concentration or interface charge density is significantly increased over that for known semiconductor structures by incorporating an atomic planar doping layer (delta-doped layer) in close proximity to a heterointerface such that a spacer semiconductor layer separates the atomic planar doping layer from the heterointerface. The doping concentration of the atomic planar doping layer is selected to cause a selected barrier thickness for charge carriers in the conduction band of the atomic planar doping layer to be less than the spacer thickness. Moreover, the two-dimensional electron gas density is caused to exceed known device limits for homogeneously doped structures while maintaining a relatively high mobility.

In one embodiment, high transconductances are achieved for field effect transistor devices utilizing the atomic planar doping layer closely proximate the heterointerface.

In another embodiment, a delta-doped layer within a quantum well layer is included in the heterostructure to reduce persistent photoconductivity resulting from deep donors.

### Brief Description of the Drawing

A more complete understanding of the invention may be obtained by reading the following description of a specific illustrative embodiment of the invention in conjunction with the appended drawing in which:

FIG. 1 is a cross-sectional schematic diagram of a conventional selectively doped heterostructure;

FIG. 2 is an energy band diagram of the heterostructure in FIG. 1;

FIG. 3 is a cross-sectional schematic diagram of a selectively doped heterostructure including a delta doping layer in accordance with the principles of the invention;

FIG. 4 is an energy band diagram of the heterostructure in FIG. 3;

FIG. 5 is a plot of the two-dimensional electron gas concentration versus spacer layer thickness for the heterostructures in FIGs. 1 and 3; and

FIG. 6 is an energy band diagram for the heterostructure in FIG. 3 modified to include at least one quantum well layer.

Detailed Description

It is understood by those skilled in the art that the term "atomic planar doping" is equivalent to the term "delta-doping" which is used interchangeably herein. It is further understood that figures within the drawing are not to scale and are provided to assist in the understanding of the invention. While it is understood that the principles of this invention are applicable to many types of electronic, optoelectronic and photonic devices, it is described below with reference to an electronic device, the field effect transistor. This is for purposes of explication and not limitation.

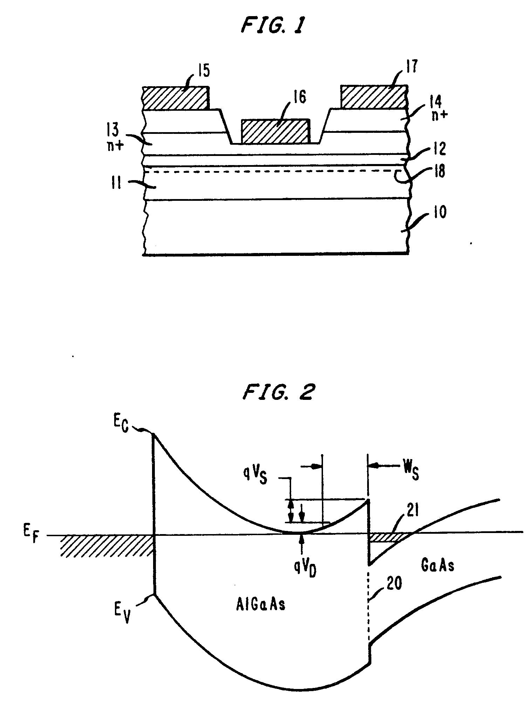

FIG. 1 shows in cross-sectional view a schematic diagram of a conventional selectively doped heterostructure field effect transistor. For purposes of the following description, the field effect transistor is comprised of Group III-V semiconductor materials and, more particularly, materials selected from the AlGaAs/GaAs system. The selectively doped heterostructure field effect transistor generally includes an undoped or semi-insulating GaAs substrate 10 upon which is grown the following sequence of layers: an undoped GaAs channel layer 11, an undoped AlGaAs spacer layer 12, a doped AlGaAs donor layer 13, and doped GaAs cap layers 14. Standard photolithographic techniques and chemical etching are used to create a gate recess to accommodate a gate contact over the channel layer. Metallic contacts 15 and 17 are formed over the source and drain regions respectively, and are ohmic in nature. Metallic contact 16 is formed over the gate region and is typically a Schottky barrier contact.

Molecular beam epitaxial growth techniques are used to fabricate devices similar to that shown in FIG 1 and described above. For a more complete understanding of the device shown in FIG 1 and fabrication techniques therefor, see "VLSI Electronics Microstructure Science: GaAs Microelectronics (Volume 11)", Ed. by N. G. Einspruch et al., pages 215-64 (Academic Press, Inc. 1985).

In practice, channel layer 11 is less than 1.0 $\mu$m. in thickness; spacer layer 12 is approximately 20-80 Angstroms thick; donor layer 13 is approximately 300-500 Angstroms thick with a dopant concentration of approximately $10^{18} cm^{-2}$ for Si; and cap layer 14 has a thickness between 0-500 Angstroms with a dopant concentration similar to that for layer 13. For these dimensions and dopant concentrations, the two-dimensional electron gas density falls in the range 0.5 to 1.5x $10^{12} cm^{-2}$. Dashed line 18 depicts the location of two-dimensional electron gas within the device.

It is well known that transconductance ($g_m = dI_{ds}/dV_g$) of devices such as the one shown in FIG 1 depends critically upon the separation between the gate and the location of the two-dimensional electron gas shown by line 18. However, it is also known that, in the AlGaAs/GaAs system, it is quite difficult in conventional selectively doped heterostructure field effect transistors to exceed two-dimensional electron gas densities around 1 x $10^{12} cm^{-2}$ while retaining favorable electron mobilities.

FIG. 2 shows an energy band diagram for the heterostructure shown in FIG. 1. $E_F$, $E_C$ and $E_V$ represent the Ferni, conduction and valence energies, respectively. Dashed line 20 represents the heterointerface between layers 11 and 12 in FIG. 1. The two-dimensional electron gas layer is represented by hatched area 21. Spacer layer thickness is represented as $W_s$. $V_D$ is the potential drop in the depletion region ($qV_D$ is the energy) and $V_s$ represents the potential drop across the spacer layer. Baud shape is determined by homogeneously and uniformly doping layers 13 and 14.

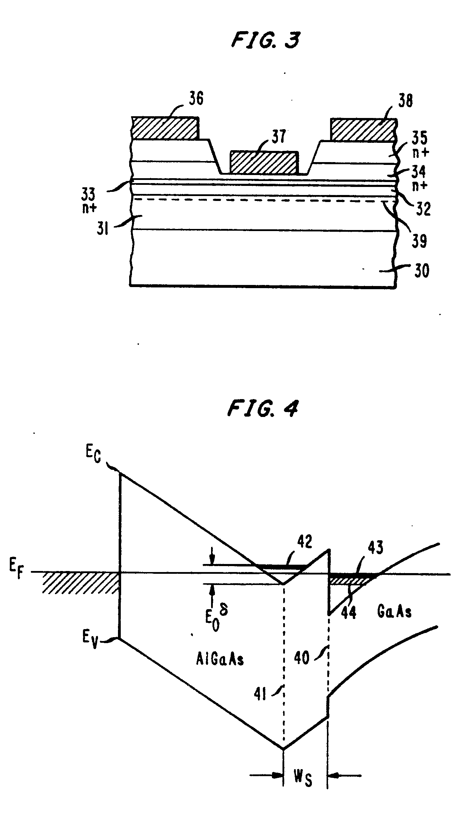

FIG. 3 shows in cross-sectional view a selectively doped heterostructure field effect transistor including a delta-doped layer 32 in close proximity to the heterointerface between channel layer 31 and spacer layer 32. The transistor includes a semi-insulating or intrinsic GaAs substrate layer 30 upon which is epitaxially grown the following sequence of layers: undoped GaAs channel layer 31; undoped AlGaAs spacer layer 32; delta-doping layer 33; doped AlGaAs donor layer 34; and doped GaAs cap layers 35. Source contact 36, drain contact 38 and gate contact 37 are metallic contacts. Fabrication techniques are substantially identical to those employed for the device shown in FIG. 1.

Heterostructures such as shown in FIG. 3 have been grown in a Varian Generator V80 gas source molecular beam epitaxy system. This is a horizontal growth chamber equipped with conventional Group III sources. Arsenic flux has been provided by thermally decomposed arsine.

Channel layer 31 is approximately 1.0μm thick; the AlGaAs spacer layer 32 is grown to a thickness between 0 and 100 Angstroms. Delta-doping layer 33 comprising a submonolayer dose of Si (n-type dopant) to achieve a sheet of carrier concentration greater than or equal to $N_D^\delta = 4.0 \times 10^{12}$ cm$^{-2}$. Donor layer 34 and cap layer 35 are then grown to conventional thicknesses and carrier concentrations.

It is also contemplated, although not shown in FIG. 3, that delta-doping layer 33 be grown within spacer layer 32 by interrupting the growth of layer 32 with an intervening, precalibrated, submonolayer dopant (Si for n-type) dose substantially at a distance $W_s$ from the heterointerface. Growth of the remaining portion of layer 32 is then resumed to completion over delta doping layer 33. For this structure, growth of donor layer 34 follows over layer 32 including layer 33. The thickness for entire layer 32 in this structure is substantially in the range of 0 to 1000 Angstroms.

In an example from experimental practice, the transistor shown in FIG. 3 has been fabricated with a gate width of 150μm, a gate length of 1.2μm and a source-to-drain spacing of 4.0μm. Contacts for the device were comprised of alloyed multilayer ohmic (source and drain) contacts and a multilayer Schottky (gate) contact. The ohmic contact included layers of 2000 Angstroms AuGe (eutectic), 400 Angstroms Ni and 2000 Angstroms Au; the Schottky contact was comprised of layers of 500 Angstroms Ti and 1500 Angstroms Au.

It has been found that very high transconductances are achieved by such devices. In room temperature operation, gm in the range 320-350 mS/mm was observed for a 1.2μm gate device in depletion mode operation. At low temperatures (T = 77k), transconductance over 420 mS/mm is obtained. No significant degradation of electron mobility is observed for these devices. .

Delta doping permits localization of dopant atom impurities within a single monolayer of the host semiconductor crystal. In the particular examples given herein, Si atoms replace some Group III sites to generate a v-shaped potential well in the conduction band along the direction perpendicular to the heterointerface. This is shown clearly in FIG. 4 which shows an energy band diagram for the device substantially as described in FIG. 3. The potential well in the conduction band is of sufficient strength, because of the high delta doping concentration, to quantize electrons (holes for p-type) into individual subbands at eigenstate energies $E_0$ through $E_n$ where

$$E_n \cong \frac{1}{2}(n+1)^{2/3} \left[ \frac{q^2 2\pi h N}{\epsilon \sqrt{m^*}} \right]^{2/3}, n = 0, 1, 2, \dots$$

for h as Planck's constant, m* is the effective electron mass, q is the effective element charge, $\epsilon$ is the permittivity and N is the corresponding delta doping concentration. This quantization reduces the selected barrier thickness below the spacer thickness, $W_s$. It should be clear from the diagram that the selected barrier thickness is measured from a conduction band edge of the lowest order eigenstate (filled conduction subband) to the heterointerface. The approximate energy band diagram shown in FIG. 4 depicts the heterointerface at dashed line 40 separated from the delta doped layer at dashed line 41 by a distance (spacer thickness) $W_s$. Region 42 shows subband filling of the lowest eigenstate $E_0$ in the substantially sharp v-shaped potential well caused by delta doping. In the triangular quantum well present in the channel layer beyond the heterointerface, cross-hatched regions 43 and 44 represent lowest order eigenstates in the conduction channel.

As is apparent from FIG. 4, the substantially sharp v-shaped potential well caused by the delta doping layer induces a concomitant quantum size effect thereby permitting the selected barrier thickness seen by electrons in region 42 to be less than the spacer layer thickness, $W_s$. In essence, there is a conduction band discontinuity which is enhanced over the conventional structure. Also, the potential drop $V_D$ is not present in FIG. 4 because of the localization of donor impurities caused by delta doping.

In comparison with known modulation doping structures, the two-dimensional electron gas density positioned approximately at dashed line 39 is nearly two times larger for the present delta doping layer structure over conventional devices having comparable spacer thicknesses, $W_s$. For example, with an Al mole fraction x = 0.3 (Al$_x$Ga$_{1-x}$As) and a spacer thickness $W_s$ = 50 Angstroms, the uniformly doped

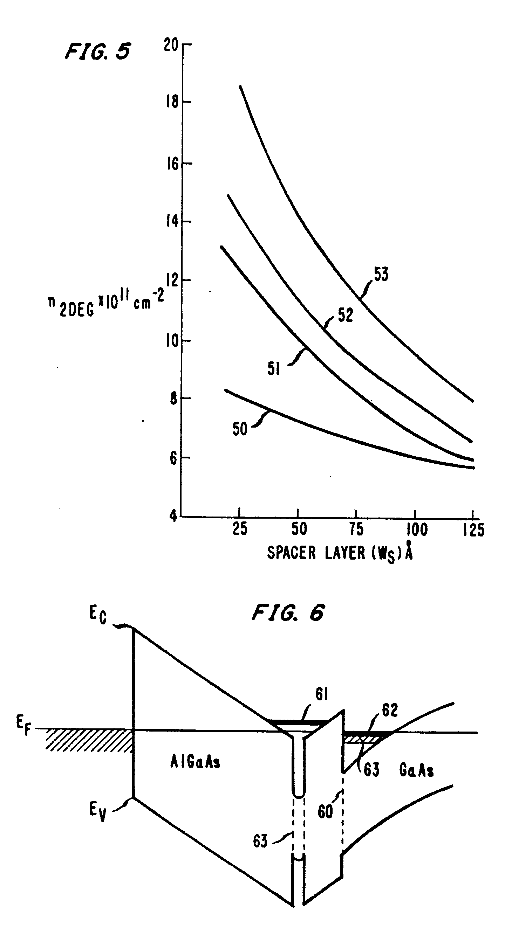

($N_D = 2 \times 10^{18} cm^{-2}$) structure of FIG. 1 exhibits a two-dimensional electron gas density of $1.04 \times 10^{12} cm^{-2}$ whereas a significantly higher concentration $1.96 \times 10^{12} cm^{-2}$ is obtained for the delta doped ($N_D^{\delta} = 5 \times 10^{12} cm^{-2}$) heterostructure of FIG. 3. This comparison is further explicated in FIG. 5 wherein curves 50 and 51 refer to conventional uniformly doped heterostructures having doping concentrations of $10^{18}$ and $\infty cm^{-2}$, respectively, whereas curves 52 and 53 refer to heterostructures having a delta doping layer at a distance $W_s$ from the interface and the sheet doping concentrations are $5 \times 10^{12}$ and $1 \times 10^{13} cm^{-2}$, respectively.

FIG. 6 shows an energy band diagram for a heterostructure similar to that in FIG. 3 wherein a quantum layer depicted as dashed region 63 is grown over the spacer layer and includes, at a distance $W_s$ from the heterointerface shown as dashed line 60, a delta doping layer. Regions 61, 62 and 63 refer to eigenstate energy bands above the conduction band caused by size quantization. For reasonably thin quantum wells (< 10 Angstroms in GaAs), it is possible to reduce persistent photoconductivity associated with deep donors by spatially separating donors in AlGaAs. Moreover, the benefits derived from the strong delta doping densities in close proximity to the heterointerface are maintained.

It is understood by those skilled in the art that devices based upon the principles of this invention will exhibit higher speeds because of the increased carrier density and relatively high mobility.

While the description above has been confined for clarity to describing a single delta doping layer, it is understood that multiple delta doping layers of like and/or opposite conductivity may be substituted for the single layer. Similarly, silicon as a dopant may be exchanged for other n-type dopants such as tin, germanium, sulfur and selenium. Also, complementary logic having layers doped oppositely to those shown in the FIGS. may be substituted therefor.

## Claims

1. A semiconductor structure comprising
a first semiconductor layer comprised of a first material composition
a second semiconductor layer comprised of a second material composition, said first and second semiconductor layers substantially abutting along a common boundary to form a heterointerface therealong, said structure being characterized in that
said second semiconductor layer includes an atomic planar layer comprised of a third material composition for delta doping said second semiconductor layer at a predetermined distance from said heterointerface, a doping density of said atomic planar layer being sufficiently high to reduce a selected barrier thickness below said predetermined distance.

2. The semiconductor structure defined in Claim 1 wherein the first and second material compositions are selected from the group consisting of Group III-V semiconductor compounds.

3. The semiconductor structure defined in Claim 1 wherein the first material composition is comprised of gallium arsenide, the second material composition is comprised of aluminium gallium arsenide, and the third material composition is chosen from the group consisting of n-type and p-type dopant materials for a gallium arsenide system.

4. The semiconductor structure defined in Claim 1 or 2 or 3 wherein said predetermined distance is greater than 0 Angstroms and said doping density is greater than or equal to $4.0 \times 10^{12} cm^{-2}$.

5. The semiconductor structure defined in Claim 4 wherein said third material composition includes silicon.

6. A semiconductor structure comprising
a first semiconductor layer comprised of a first material composition
a second semiconductor layer comprised of a second material composition, said first and second semiconductor layers substantially abutting along a common boundary to form a heterointerface therealong, said structure being characterized in that said second semiconductor includes at least one quantum well region comprised of a third material composition, said at lest one quantum well region including an atomic planar layer comprised of a fourth material composition for delta doping, said at least one quantum well region at a predetermined distance from said heterointerface, a doping density of said atomic planar layer being sufficiently high to reduce a selected barrier thickness below said predetermined distance.

7. The semiconductor structure defined in Claim 6 wherein the first, second and third material compositions are selected from the group consisting of Group III-V semiconductor compounds.

8. The semiconductor structure defined in Claim 6 wherein the first and third material compositions are comprised of gallium arsenide, the second material composition is comprised of aluminum gallium arsenide, and the fourth material composition is chosen from the group consisting of n-type and p-type dopant materials for a gallium arsenide system.

9. The semiconductor structure defined in Claim 6 or 7 or 8 wherein said predetermined distance is greater than 0 Angstroms and said doping density is greater than or equal to $4.0 \times 10^{12}$ cm$^{-2}$.

10. The semiconductor structure defined in Claim 9 wherein said at least one quantum well region is less than or equal to 10 Angstroms thick as measured normal to said heterointerface.

11. The semiconductor structure as defined in Claim 9 wherein said fourth material composition includes silicon.

12. The semiconductor structure as defined in Claim 10 wherein said fourth material composition includes silicon.

*FIG. 1*

*FIG. 2*

## FIG. 3

## FIG. 4

FIG. 5

FIG. 6